# EUROPEAN PATENT APPLICATION

(11) **EP 4 787 117 A1**
(43) Date of publication of application: **05.08.2026**
(21) Application number: 26154972.9
(22) Date of filing: 29.01.2026
(51) Int. Cl.: G06F 1/20, H05K 7/20

(54) **CONTINUOUS MONITORING OF CHILLER HEALTH TO ENABLE GENTLE DEVICE SHUTDOWN IN EVENT OF CHILLER FAILURE**

(30) Priority: 29.01.2025 US 202563750970 P; 23.01.2026 US 202619457786
(71) Applicant: Vertiv Corporation, Westerville, OH 43082 (US)
(72) Inventor: WISE, Ashley Elizabeth, Westerville, 43082 (US); TIPTON, Russell Charles, Westerville, 43082 (US)
(74) Representative: Ambroz, Simon

(57) **Abstract**

A system and method for continuous real-time monitoring of a primary chiller device of a pumped two-phase chiller system includes flow rate and outlet temperature sensors within the primary chiller device, continually sensing a flow rate and outlet temperature of a primary fluid refrigerant leaving the primary chiller device to circulate through a pumping unit and transfer heat absorbed from downstream IT devices (and, with respect to direct-to-chip (D2C) systems, downstream chip assemblies). The pumping unit controller receives the collected flow rate and outlet temperature data and, when the flow rate and/or outlet temperature deviates from acceptable ranges, e.g., too low a flow rate, too high an outlet temperature, detects an imminent failure of the primary chiller device and responds accordingly, e.g., requesting shutdown of the primary chiller device or the downstream IT devices.

## Description

### CROSS-REFERENCE TO RELATED APPLICATIONS

The present application claims the benefit under 35 U.S.C. § 119(e) of U.S. Provisional Patent Application Serial Number 63/750,970 filed January 29, 2025, and U.S. Nonprovisional Patent Application 19/457,786 filed 23 January 2026.

### TECHNICAL FIELD

The present disclosure is directed generally to the field of cooling systems for data centers and similar controlled-temperature environments, and more particularly, to monitoring of two-phase pumping systems within a cooling system.

### BACKGROUND

Direct-to-chip (D2C) cooling systems are increasingly deployed for thermal management in high performance computing (HPC) data center environments. For example, D2C liquid cooling involves circulating a dielectric liquid refrigerant directly to computer chip surfaces, e.g., via cold plates in thermal communication with the chip assemblies, to efficiently absorb heat generated by the computer chips and remove absorbed heat from the system. Proper thermal management can maintain processor temperatures at optimal levels (e.g., above which the processor operations may be throttled or otherwise impaired).

In a two-phase D2C system, the liquid refrigerant circulates through a secondary loop which serves as the second phase of the system. The first phase involves a primary cooling device and primary loop, which absorbs heat from the secondary loop via a liquid heat exchanger and removes the absorbed heat from the system, e.g., via evaporation. As heat is transferred from the liquid refrigerant in the secondary loop, the refrigerant is recirculated through the secondary loop at a lower temperature, and returns at a higher temperature due to the heat absorbed from the downstream chip assemblies.

However, when the primary cooling device fails (assuming no redundant primary system), the adverse impact on D2C cooling capacity is immediate. Heat absorbed from the chip assemblies cannot be effectively transferred to the primary loop for removal, but downstream IT equipment may continue to run until it must be throttled or shut down due to increased chip temperatures. Further, administrators have no advance warning of a primary cooling device failure and therefore cannot offload IT workloads to provide a gentler shutdown.

### SUMMARY

In a first aspect, a pumping unit for a cooling system for a data center environment is disclosed. In examples, the cooling system may include a pumping unit or chiller device for circulating a fluid coolant through one or more downstream servers, switches, and/or other information technology (IT) devices, the fluid coolant capable of removing transferred heat from the IT devices (e.g., for removal from the data center environment and/or cooling system). The cooling system may include a controller for operating the pumps. The pumping unit may sense, and report to the controller, properties and/or characteristics of the fluid coolant, which may be different from the predetermined or intended properties (e.g., based on cooling capacity required to maintain the downstream devices within an acceptable temperature range). Based on the received sensed properties, the controller may detect a state of the primary chiller device. Based on a detected failure state, the controller may execute a failure response action.

In some examples, the sensed properties include an outlet temperature of fluid coolant leaving the pumping unit or chiller device.

In some examples, the sensed properties include a flow rate of fluid coolant leaving the pumping unit or chiller device. In some examples, the downstream IT devices are connected to a power distribution unit (PDU) from which the downstream devices receive operating power. For example, the controller may respond to a detected failure state by directing the PDU to disable or disconnect operating power to the downstream devices.

In some examples, the controller may respond to the detected failure state by initiating a shutdown of the chiller device.

In some examples, the controller may shutdown the chiller device and engage a backup cooling system or chiller device for circulating coolant through the downstream IT devices.

In some examples, the controller may be configured for control of the downstream IT devices, and may respond to a detected failure condition by initiating a gentle shutdown of the downstream IT devices.

In some examples, the gentle shutdown process may include pausing one or more workloads currently executing on the downstream IT devices, scaling down the overall workload executing on the one or more IT devices by suspending one or more currently executing workloads, and/or transferring one or more currently executing workloads to alternative IT devices, e.g., backup or secondary devices not affected by the failure condition.

In some examples, the cooling system is a direct-to-chip (D2C) cooling system wherein the fluid network is in direct thermal communication with a processor or chip assembly of a downstream IT device, e.g., via a cold plate.

In a further aspect, a pumped two-phase cooling system for a data center environment is disclosed. In examples, the cooling system may include a primary chiller device fluidly connected to a pumping unit. For example, the primary chiller device may pump or circulate a first fluid coolant to the pumping unit via a primary fluid network, according to a predetermined flow rate and/or outlet temperature. Similarly, the pumping unit may pump or circulate a second fluid coolant through one or more servers, switches, and/or IT devices within the data center environment via a secondary fluid network to remove thermal energy generated by the downstream devices. The pumping unit may include a heat exchanger via which thermal energy transferred from the downstream devices to the secondary fluid network is transferred to the primary fluid network for removal from the cooling system. The primary chiller device may include one or more sensors for monitoring and reporting properties or characteristics of primary fluid coolant leaving the device via the primary fluid network, and transmitting the reported properties to a pumping unit controller. Based on the received properties, the controller may detect a failure state of the primary chiller device, e.g., where the actual properties or characteristics significantly deviates than their predetermined or expected ranges. When a failure state is detected, the controller may execute one or more failure response actions.

In some examples, the monitored and reported properties include an outlet temperature of primary fluid coolant leaving the primary chiller device.

In some examples, the monitored and reported properties include a flow rate of primary fluid coolant leaving the primary chiller device.

In some examples, the downstream IT devices are connected to a power distribution unit (PDU) from which the downstream devices receive operating power. For example, the controller may respond to a detected failure state by directing the PDU to disable or disconnect operating power to the downstream devices.

In some examples, the controller may respond to the detected failure state by initiating a shutdown of the primary chiller device.

In some examples, the controller may respond to the detected failure state by engaging a backup primary chiller device coupled to the pumping unit or a backup cooling system to provide continued thermal management.

In some examples, the controller may respond to the detected failure state by initiating a gentle shutdown of the downstream IT devices.

In some examples, the gentle shutdown process may include pausing one or more workloads currently executing on the downstream IT devices, scaling down the overall workload executing on the one or more IT devices by suspending one or more currently executing workloads, and/or transferring one or more currently executing workloads to alternative IT devices, e.g., backup or secondary devices not affected by the failure condition.

In some examples, the two-phase cooling system is a direct-to-chip (D2C) cooling system wherein the secondary fluid network is in thermal communication with a processor or chip assembly of a downstream IT device, e.g., via a cold plate.

In a further aspect, a method for continuous monitoring of a cooling system and proactive failure response is disclosed. In examples, the method may include providing a pumping unit for circulating a fluid coolant through a fluid network to transfer thermal energy from downstream servers, switches, and/or other IT devices. The method may include sensing one or more properties or characteristics of the fluid coolant via sensors in the primary chiller device. The method may include receiving the sensed properties and/or characteristics at the pumping unit controller. The method may include detecting a failure state of the chiller device based on the reported properties, e.g., where the reported properties sufficiently deviate from predetermined levels, e.g., based on required cooling capacity. The method may include, when a failure state is detected, executing one or more failure response actions via the pumping unit controller.

In some examples, the reported properties or characteristics may include a flow rate and/or an outlet temperature of fluid coolant leaving the chiller device.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE FIGURES

The detailed description is described with reference to the accompanying figures. The use of the same reference numbers in different instances in the description and the figures may indicate similar or identical items. Various embodiments or examples ("examples") of the present disclosure are disclosed in the following detailed description and the accompanying drawings. The drawings are not necessarily to scale. In general, operations of disclosed processes may be performed in an arbitrary order, unless otherwise provided in the claims. In the drawings:
FIG. 1 is a block diagram of a pumped two-phase cooling system serving one or more IT devices according to examples of the inventive concepts disclosed herein;
FIG. 2 is a diagrammatic illustration of the pumped two-phase cooling system of FIG. 1 including downstream information technology (IT) devices; and
FIG. 3 is a process flow diagram illustrating a method for continuous charge level monitoring of a pumped two-phase cooling system according to examples of the inventive concepts disclosed herein.

### DETAILED DESCRIPTION

Before explaining one or more examples of the disclosure in detail, it is to be understood that the examples are not limited in their application to the details of construction and the arrangement of the components or steps or methodologies set forth in the following description or illustrated in the drawings. In the following detailed description of examples, numerous specific details may be set forth in order to provide a more thorough understanding of the disclosure. However, it will be apparent to one of ordinary skill in the art having the benefit of the instant disclosure that the examples disclosed herein may be practiced without some of these specific details. In other instances, well-known features may not be described in detail to avoid unnecessarily complicating the instant disclosure.

As used herein a letter following a reference numeral is intended to reference an example of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of examples disclosed herein. This is done merely for convenience and "a" and "an" are intended to include "one" or "at least one," and the singular also includes the plural unless it is obvious that it is meant otherwise.

Finally, as used herein any reference to "one embodiment/example" or "some examples" means that a particular element, feature, structure, or characteristic described in connection with the example is included in at least one example disclosed herein. The appearances of the phrase "in some examples" in various places in the specification are not necessarily all referring to the same example, and examples may include one or more of the features expressly described or inherently present herein, or any combination or sub-combination of two or more such features, along with any other features which may not necessarily be expressly described or inherently present in the instant disclosure.

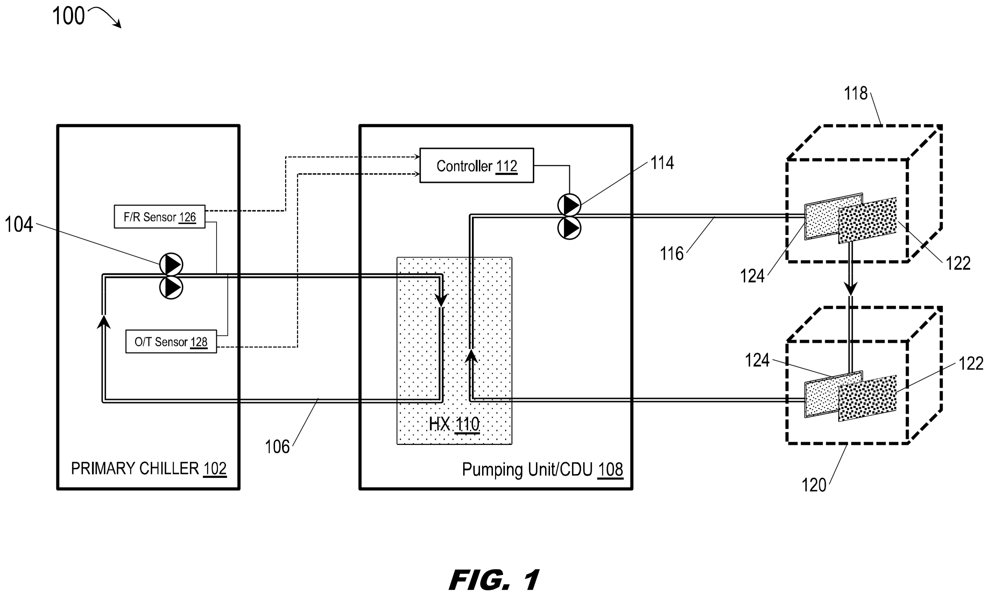

### FIG. 1 - OVERVIEW

Broadly speaking, examples of the inventive concepts disclosed herein are directed to methods and systems for continuous monitoring of primary cooling devices (also "chillers", "chiller devices") in a two-phase direct-to-chip (D2C) liquid cooling system. By providing real-time monitoring of primary chiller parameters, administrators gain precious time in the event of a failure to offload IT workloads and mitigate the impact of a shutdown. Similarly, administrators can prevent restarts of the primary cooling device while IT loads are drawn, instead initiating a gentle IT shutdown in advance of chiller maintenance.

Referring now to FIG. 1, a pumped two-phase liquid cooling system 100 is shown. The pumped two-phase cooling system 100 includes primary chiller device 102 (e.g., primary chiller, chiller device, primary cooler device) including primary pump/s 104 and primary fluid network 106 (e.g., primary loop); pumping unit 108 (e.g., coolant delivery unit, coolant distribution unit (CDU) including heat exchanger 110 (HX; e.g., liquid heat exchanger), controller 112 (e.g., including one or more processors), secondary pump/s 114, and secondary fluid network 116 (e.g., secondary loop); and downstream information technology (IT) devices 118, 120 (e.g., servers, switches, and other like devices incorporating heat-generating processors and chips).

In examples, the pumped two-phase liquid cooling system 100 may be implemented in a data center or like environment, e.g., as a direct-to-chip (D2C) cooling system where the pumping unit 108 circulates (e.g., via secondary pump/s 114) a secondary liquid refrigerant through the secondary fluid network 116 (e.g., as opposed to a primary fluid refrigerant circulated through the primary fluid network 106) to the downstream IT devices 118, 120 (e.g., servers, switches), wherein the secondary liquid refrigerant is brought into contact with chip assemblies 122. For example, the secondary fluid refrigerant may be a dielectric coolant fluid brought into contact with cold plates 124 within the downstream IT devices 118, 120. Further, the cold plates may be in direct thermal communications with the chip assemblies 122 such that heat generated by the processor chips within the downstream IT devices 118, 120 is absorbed by the cold plates 124 and transferred to the secondary fluid refrigerant.

In examples, the secondary fluid refrigerant may leave the pumping unit 108 at a desired outlet temperature and return to the pumping unit (e.g., via the secondary fluid network 116) at a higher return temperature, indicative of heat absorbed from the downstream IT devices 118, 120. For example, heat transferred to the secondary fluid network 116 may then be transferred to the primary fluid network 106 by the heat exchanger 110 within the pumping unit 108. Similarly, the primary chiller device 102 may circulate a primary fluid refrigerant (e.g., water, water/glycol mixture) through the primary fluid network 106 such that the primary fluid refrigerant leaves the primary chiller device at a predetermined flow rate and outlet temperature and returns to the primary chiller device at a higher return temperature, again reflecting heat transferred to the primary fluid network 106 from the secondary fluid network 116 via the heat exchanger 110.

In examples, the primary chiller device 102 may dissipate or otherwise remove from the pumped two-phase liquid cooling system 100 any heat transferred to the primary fluid network 106 via, e.g., evaporation or air cooling, such that the primary fluid refrigerant is substantially restored to the target outlet temperature for recirculation through the primary fluid network 106. For example, the outlet temperature and flow rate at which the primary fluid refrigerant leaves the primary chiller device 102 via the primary fluid network 106 may be selected based on an anticipated current load (e.g., operating power) drawn by the downstream IT devices 118, 120 and the corresponding cooling capacity required to remove from the pumped two-phase liquid cooling system 100 the heat generated by the anticipated current load.

In examples, the primary chiller device 102 may experience component failures that inhibit or preclude entirely the ability of the primary chiller device to transfer heat from the primary fluid network 106 and remove the transferred heat from the pumped two-phase liquid cooling system 100 (e.g., to the outside air), thereby maintaining the downstream IT devices 118, 120 within a target temperature range. For example, the primary chiller device 102 may experience a condenser failure or other similar failure of its refrigeration/heat dissipation components, the result being a reduced capacity, or a loss of capacity, to maintain the desired outlet temperature of primary fluid refrigerant circulating through the primary fluid network 106. Further, if the outlet temperature of the primary fluid refrigerant in the primary fluid network 106 cannot be maintained, the capacity of the primary fluid refrigerant to absorb heat from the secondary fluid network 116 via the heat exchanger 110 may be reduced.

Similarly, the primary chiller device 102 may experience a failure of the primary pump/s 104, such that primary fluid refrigerant cannot circulate through the primary fluid network 106 and heat transferred to the primary fluid network from the secondary fluid network 116 (e.g., via heat exchanger 110) cannot be returned to the primary chiller device 102 for removal from the system. Further, as the temperature of the primary fluid refrigerant within the primary fluid network 106 increases, the heat exchanger 110 can no longer effectively transfer heat from the secondary fluid network 116 to the primary fluid network. In both of the above cases-a refrigeration failure resulting in higher outlet temperature, or a pump failure resulting in lower or nonexistent flow rate-the end result is the inability of the pumped two-phase liquid cooling system 100 to maintain the chip assemblies 122 and/or the downstream IT devices 118, 120 within the target temperature range, and the eventual throttling or shutdown of the downstream IT devices 118, 120 when temperatures within the chip assemblies reach critical levels. Further, when there is no monitoring of the primary chiller device 102, this throttling or shutdown may occur without prior warning, leaving no time to offload IT workloads before the shutdown.

In examples, the primary chiller device 102 may be configured for real time monitoring via the addition of a flow rate sensor 126 and outlet temperature sensor 128. For example, the flow rate sensor 126 may monitor the flow rate of primary fluid refrigerant leaving the primary chiller device 102 via the primary fluid network 106. Similarly, the outlet temperature sensor 128 may monitor the outlet temperature of the primary fluid refrigerant leaving the primary chiller device 102 via the primary fluid network 106.

In examples, the controller 112 within the pumping unit 108 may receive, at predetermined intervals, a flow rate and outlet temperature of primary fluid refrigerant leaving the primary chiller device 102 as collected by the flow rate sensor 126 and outlet temperature sensor 128. For example, the flow rate sensor 126 and outlet temperature sensor 128 may include Redfish or other appropriate compatible sensors capable of continuous data collection and forwarding of collected data, e.g., via wireless or physical communications links, to the controller 112.

In examples, the controller 112 may include one or more processors as well as memory or appropriate data storage. For example, the controller 112 may store thresholds, acceptable ranges, and/or other parameters associated with failure conditions of the primary chiller device 102. Based on a deviation of either or both of the collected flow rate or the collected outlet temperature beyond acceptable ranges or away from threshold levels, the controller 112 may determine an imminent failure of the primary chiller device 102. For example, a flow rate below the acceptable threshold may be indicative of a failure of the primary pump/s 104. Similarly, an outlet temperature above the acceptable threshold may be indicative of a failure of condenser or other refrigeration equipment allowing the primary chiller device 102 to remove from the pumped two-phase liquid cooling system 100 heat transferred to the primary fluid network 106.

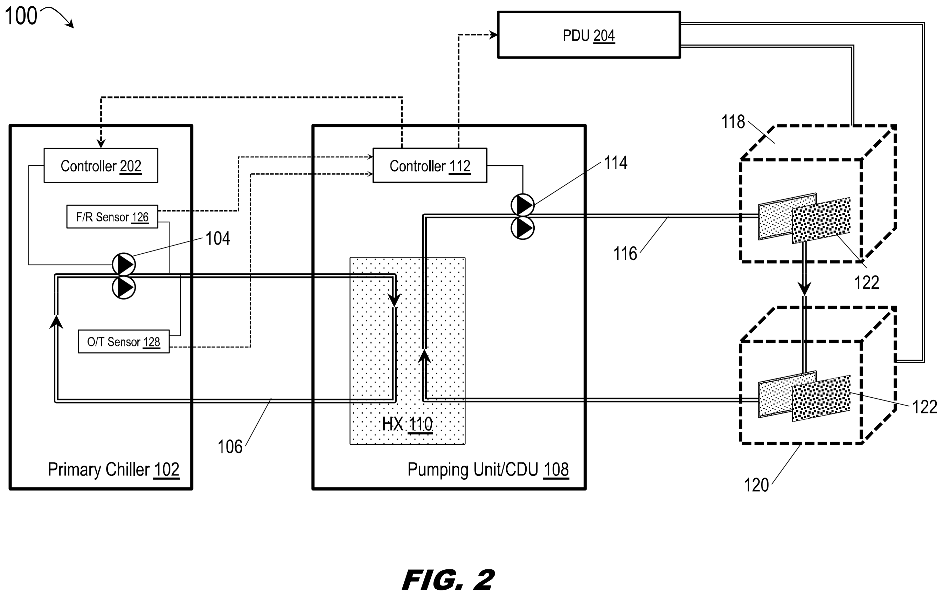

### FIG. 2 - FAILURE RESPONSES

Referring now to FIG. 2, the pumped two-phase liquid cooling system 100 is shown.

In examples, when the controller 112 of the pumping unit 108 detects an imminent failure of the primary chiller device 102, the controller may execute one or more failure responses. For example, the controller 112 may initiate an immediate shutdown of the primary chiller device 102 by transmitting a shutdown request to the controller 202 of the primary chiller device. An immediate shutdown of the primary chiller device 102 may mitigate the rise in chip assembly (122) temperatures otherwise associated with primary chiller device failure as discussed above, providing administrators with a time window within which to offload current IT workloads associated with current loads drawn by the downstream IT devices 118, 120 before a shutdown of the downstream IT devices is necessary.

In examples, the controller 112 may alternatively disable operating power to the downstream IT devices 118, 120 by transmitting a disable request to a power distribution unit 204 (PDU) from which the downstream IT devices are drawing operating power. For example, the controller 112 may direct the PDU 204 to disable operating power or discontinue any current loads drawn by the downstream IT devices 118, 120, e.g., either immediately or after a shutdown interval.

In examples, monitoring of the primary chiller device 102 by the controller 112 may prevent maintenance personnel from inadvertently triggering an IT failure associated with servicing the primary chiller device 102. For example, if the primary chiller device 102 is taken offline for maintenance without offloading any current IT workloads handled by the downstream IT devices 118, 120, coolant temperatures within the secondary fluid network 116, and by extension temperatures within the chip assemblies 122, may be adversely affected as described above and an involuntary and unforeseen throttling or shutdown of the downstream IT devices 118, 120 may result. Accordingly, in examples the controller 112 may generate an alert if a failure condition of the primary chiller device 102 is detected, e.g., a sudden loss of flow rate associated with a shutdown of the primary cooling device for maintenance. For example, the alert may be auditory, or may be displayed via a display unit of the pumping unit 108 to any individuals proximate to the pumping unit, or may be transmitted to a remotely located user.

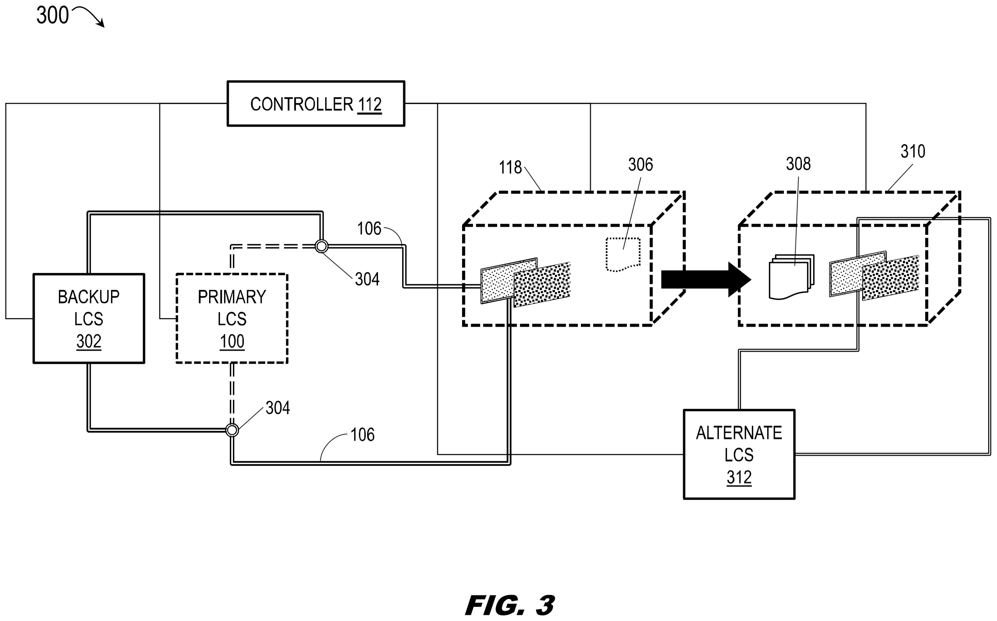

### FIG. 3 - ALTERNATE FAILURE RESPONSES

Referring now to FIG. 3, a data center environment 300 is shown.

In examples, the controller 112 may maintain full or partial operative control of additional cooling systems and/or the downstream IT devices 118. For example, the pumped liquid cooling system 100 may be a primary single-phase or multiple-phase cooling system. In examples, when a failure condition is detected within the pumped liquid cooling system 100 (e.g., within a chiller device 102 or fluid network 106, based on sufficiently deviant flow rate, outlet temperature, and/or other properties and characteristics of the fluid refrigerant or coolant circulating through the fluid network), the controller 112 may engage a backup cooling system 302. For example, the backup cooling system 302 may include chiller devices coupled to the fluid network 106, e.g., via valves 304. Accordingly, the controller 112 may disengage the failed or deviant pumped liquid cooling system 100 in favor of the backup cooling system 302 to maintain thermal management of the downstream IT devices 118 with little or no interruption or threat to the IT devices and/or workloads currently executing thereon.

In some examples, the controller 112 may respond to a detected failure condition by initiating a gentle shutdown of the downstream IT devices 118. For example, the controller 112 may scale down processing on the downstream IT devices 118 prior to shutdown, e.g., via suspending or pausing some or all workloads 306 currently executing on the downstream IT devices 118. In some examples, the controller 112 may transfer one or more workloads 308 to other downstream IT devices 310 for completion. For example, the alternative other downstream IT devices 310 may be served by an alternative cooling system 312 also monitored by the controller 112.

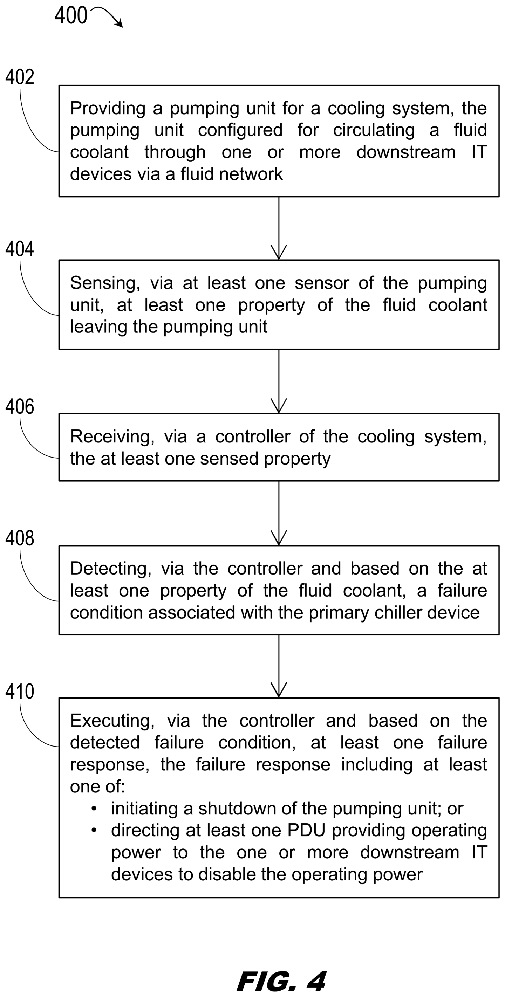

### FIG. 4 - METHOD

In examples, the method 400 may be implemented within the pumped two-phase liquid cooling system 100 and may include the following steps.

At a step 402, a pumping unit is provided for a cooling system in a data center environment. For example, the cooling system may include a chiller device or pumping unit for circulating a fluid refrigerant or coolant to and through downstream information technology (IT) devices to transfer thermal energy generated therein (e.g., for return to the pumping unit and removal from the data center environment). The cooling system may be a single-phase or multiple-phase system (employing in the latter case, e.g., primary and secondary fluid networks connected via heat exchangers within a secondary pumping unit or coolant delivery unit (CDU) for circulating the refrigerant directly to the IT devices. The primary fluid refrigerant may include water or a water/glycol mixture, while the secondary fluid refrigerant may include a dielectric liquid coolant. Single-phase or multiple-phase cooling systems may include direct-to-chip (D2C) systems wherein the fluid networks are in direct thermal communication with chip assemblies within the IT devices, e.g., via cold plates or similar thermal communication or exchange devices.

At a step 404, sensors within the chiller device monitor properties or characteristics associated with fluid refrigerant leaving the chiller device via the fluid network. For example, the chiller device may provide the fluid refrigerant according to a predetermined flow rate and/or outlet temperature, e.g., based on required cooling capacity.

At a step 406, the controller of the pumping unit receives the reported properties (e.g., flow rate and/or outlet temperature). For example, properties may be reported via Redfish or appropriate similar wireless communications or networking protocol.

At a step 408, based on the current reported properties of the fluid coolanta, the controller of the pumping unit may detect an imminent failure condition associated with the chiller device. For example, when flow rate falls below a threshold level, or outlet temperature rises beyond a threshold level (or when other properties or characteristics sufficiently deviate from acceptable levels), the controller may detect imminent failure of the chiller device.

At a step 410, based on the detected failure condition, the controller executes a failure response. For example, the controller may generate an alert, e.g., an auditory alert, a visual alert displayed via a display unit of the pumping unit, and/or an alert transmitted to a remote user. In some examples, the controller responds by requesting a shutdown of the chiller device. In some examples, the controller responds by requesting a disengagement of operating power provided by downstream IT devices by a power distribution unit (PDU); for example, the downstream IT devices include chip assemblies thermally managed by the downstream IT devices, e.g., direct-to-chip (D2C) cooling systems. In some examples, the controller may respond to a failure condition by engaging a backup cooling system to maintain thermal management of the downstream IT devices. In some examples, the controller may respond to a failure condition by initiating a gentle shutdown of the downstream IT devices. For example, the controller may scale down, pause, or suspend some or all workloads currently executing on the downstream IT devices. Further, the controller may transfer some or all suspended, paused, or executing workloads to alternative IT devices (e.g., not served by the failing chiller device, served by alternative chiller devices) for completion.

### CONCLUSION

Examples of the inventive concepts disclosed herein may provide critical time to protect downstream IT devices and/or direct-to-chip (D2C) cooling systems in the event of a chiller failure (e.g., a pump or condenser failure) via proactive response, e.g., by initiating a shutdown of the chiller system and/or offloading current workloads prior to initiating a gentle shutdown of the downstream IT devices. Whether an event involves a chiller failure event or routine chiller maintenance, downstream IT devices may be protected before the downstream effects of cooling capacity loss due to an inactive or low-functioning chiller lead to throttling and/or jeopardizing hardware or workloads.

The apparatuses and methods described in this application may be partially or fully implemented by a special-purpose computer created by configuring a generalpurpose computer to execute one or more particular functions embodied in computer programs. The functional blocks, flowchart components, and other elements described above serve as software specifications, which can be translated into computer programs by the routine work of a skilled technician or programmer.

The computer programs include processor-executable instructions that are stored on at least one non-transitory, tangible computer-readable medium. The computer programs may also include or rely on stored data. The computer programs may encompass a basic input/output system (BIOS) that interacts with the hardware of the special-purpose computer, device drivers that interact with particular devices of the special-purpose computer, one or more operating systems, user applications, background services, background applications, etc.

The computer programs may include: (i) descriptive text to be parsed, such as HTML (hypertext markup language), XML (extensible markup language), or JSON (JavaScript Object Notation) (ii) assembly code, (iii) object code generated from source code by a compiler, (iv) source code for execution by an interpreter, (v) source code for compilation and execution by a just-in-time compiler, etc. As examples only, source code may be written using syntax from languages including C, C++, C#, Objective-C, Swift, Haskell, Go, SQL, R, Lisp, Java^{®}, Fortran, Peri, Pascal, Curl, OCaml, Javascript^{®}, HTML5 (Hypertext Markup Language 5th revision), Ada, ASP (Active Server Pages), PHP (PHP: Hypertext Preprocessor), Scala, Eiffel, Smalltalk, Erlang, Ruby, Flash^{®}, Visual Basic^{®}, Lua, MATLAB, SIMULINK, and Python^{®}.

Process flowcharts discussed herein illustrate the operation of possible implementations of systems, methods, and computer program products according to various examples of the present invention. In this regard, each block in the flowchart may represent a module, segment, or portion of code, which comprises one or more executable instructions for implementing the specified logical function(s). It should also be noted that, in some alternative implementations, the functions noted in the blocks might occur out of the order depicted in the figures. For example, blocks shown in succession may be executed substantially concurrently. It will also be noted that each block of flowchart illustration can be implemented by special-purpose hardware-based systems that perform the specified functions or acts, or combinations of special-purpose hardware and computer instructions.

The foregoing description, for purposes of explanation, used specific nomenclature to provide a thorough understanding of the described examples. However, it will be apparent to one skilled in the art that the specific details are not required in order to practice the described examples. Thus, the foregoing descriptions of the specific examples described herein are presented for purposes of illustration and description. They are not intended to be exhaustive or to limit the examples to the precise forms disclosed. It will be apparent to one of ordinary skill in the art that many modifications and variations are possible in view of the above teachings.

Described herein are also the following clauses:
1. A cooling system, comprising: a chiller device including, one or more pumps capable of circulating a fluid coolant through one or more downstream information technology (IT) devices via a fluid network, and one or more sensors configured for reporting at least one property of the fluid coolant leaving the chiller device; and a controller including at least one processor configured to: receive from the one more sensors the at least one reported property of the fluid coolant; based on at least one property of the fluid coolant, detect a failure condition associated with the primary chiller device; and based on the detected failure condition, execute at least one failure response.
2. The cooling system of clause 1, wherein the at least one property includes an outlet temperature of the fluid coolant.
3. The cooling system of any preceding clause, wherein the at least one property includes a flow rate of the fluid coolant.
4. The cooling system of any preceding clause, wherein the one or more downstream IT devices are physically connected to at least one power distribution unit (PDU) and configured to draw operating power therefrom; and wherein the at least one failure response includes directing the at least one PDU to disable the operating power.
5. The cooling system of any preceding clause, wherein the at least one failure response includes initiating a shutdown of the chiller device.
6. The cooling system of clause 4, wherein the cooling system is a first cooling system, the fluid network is a first fluid network, the fluid coolant is a first fluid coolant, and: wherein the at least one failure response includes engaging at least one second cooling system operatively coupled to the controller, the at least one second cooling system configured for circulating a second fluid coolant through the one or more IT devices via a second fluid network.
7. The cooling system of any clause 1 to 4, wherein the at least one failure response includes initiating a shutdown of the one or more downstream IT devices.
8. The cooling system of clause 5, wherein the one or more downstream IT devices are first IT devices wherein at least one workload is configured for execution, and initiating the shutdown includes one or more of: pausing the at least one executing workload; suspending the at least one executing workload; or transferring the at least one executing workload to one or more second IT devices operatively coupled to the controller.
9. The cooling system of any preceding clause, wherein the two-phase cooling system is a direct-to-chip (D2C) cooling system, and: wherein the secondary fluid network is in thermal contact with at least one cold plate, the at least one cold plate in thermal communication with at least one of a chip or a processor of the one or more downstream IT devices.
10. A pumped two-phase cooling system, comprising: a primary chiller device fluidly coupled to a primary fluid network, the primary chiller device including: at least one primary pump configured to circulate a primary fluid through the primary fluid network, and at least one sensor configured to collect and transmit at least one property corresponding to the primary fluid leaving the primary chiller device; a pumping unit fluidly coupled to the primary chiller device via the primary fluid network, the pumping unit including: at least one secondary pump configured to circulate a secondary fluid between the pumping unit and one or more downstream information technology (IT) devices via a secondary fluid network; a heat exchanger configured for thermally connecting the primary fluid network and the secondary fluid network; a controller operatively coupled to the at least one secondary pump and wirelessly connected to the at least one sensor, the controller including at least one processor configured to: receive from the at least one sensor the at least one property of the primary fluid; based on the at least one property, detect a failure condition associated with the primary chiller device; and based on the detected failure condition, execute at least one failure response.
11. The pumped two-phase cooling system of clause 7, wherein the at least one property includes an outlet temperature of the primary fluid leaving the primary chiller device.
12. The pumped two-phase cooling system of any clause 7 to 11, wherein the at least one property includes a flow rate of the primary fluid leaving the primary chiller device.
13. The pumped two-phase cooling system of any clause 7 to 12, wherein: wherein the one or more downstream IT devices are physically connected to at least one power distribution unit (PDU) and configured to draw operating power therefrom; and wherein the at least one failure response includes directing the at least one PDU to disable the operating power.
14. The pumped two-phase cooling system of any clause 7 to 13, wherein the at least one failure response includes initiating a shutdown of the primary chiller device.
15. The pumped two-phase cooling system of clause 10, wherein the cooling system is a first cooling system, and: wherein the one or more downstream IT devices are operatively coupled to at least one backup cooling system configured to circulate a second fluid coolant through the one or more downstream IT devices via a backup fluid network; and wherein initiating the shutdown of the primary chiller device includes engaging the at least one backup cooling system.
16. The pumped two-phase cooling system of any clause 7 to 15, wherein the pumped two-phase cooling system is a direct-to-chip (D2C) cooling system, and: wherein each of the one or more downstream IT devices includes at least one cold plate in thermal communication with at least one of a chip or a processor of the downstream IT device; and wherein the secondary fluid network is in direct thermal contact with the at least one cold plate.
17. The pumped two-phase cooling system of clause 7, wherein: the controller is operatively coupled to the one or more downstream IT devices; wherein one or more workloads are configured for execution on the one or more downstream IT devices; and wherein the at least one failure response includes initiating a shutdown of the one or more downstream IT devices.
18. The pumped two-phase cooling system of clause 12, wherein: the one or more downstream IT devices are first IT devices; wherein at least one workload is configured for execution on the one or more first IT devices; and wherein initiating the shutdown includes one or more of: pausing the at least one executing workload; suspending the at least one executing workload; or transferring the at least one executing workload to one or more second IT devices operatively coupled to the controller.
19. A method for continuous chiller monitoring of a cooling system, the method comprising: providing a pumping unit for a cooling system, the pumping unit configured for circulating a fluid coolant through one or more downstream information technology (IT) devices via a fluid network; sensing, via at least one sensor of the pumping unit, at least one property of the fluid coolant leaving the pumping unit; receiving, via a controller of the cooling system, the at least one sensed property; detecting, via the controller and based on the at least one property of the fluid coolant, a failure condition associated with the primary chiller device; and executing, via the controller and based on the detected failure condition, at least one failure response, the failure response including at least one of: initiating a shutdown of the pumping unit; or directing at least one power distribution unit (PDU) providing operating power to the one or more downstream IT devices to disable the operating power.
20. The method of clause 14, wherein sensing the at least one property of the fluid coolant leaving the pumping unit includes at least one of: sensing an outlet temperature of the fluid coolant; or sensing a flow rate of the fluid coolant.

## Claims

1. A cooling system, comprising:
a chiller device including,
one or more pumps capable of circulating a fluid coolant through one or more downstream information technology (IT) devices via a fluid network,
and
one or more sensors configured for reporting at least one property of the fluid coolant leaving the chiller device;
and
a controller including at least one processor configured to:
receive from the one more sensors the at least one reported property of the fluid coolant;
based on at least one property of the fluid coolant, detect a failure condition associated with the chiller device;
and
based on the detected failure condition, execute at least one failure response.

2. The cooling system of claim 1, wherein the at least one property includes an outlet temperature of the fluid coolant; and/or
wherein the at least one property includes a flow rate of the fluid coolant.

3. The cooling system of any preceding claim, wherein the one or more downstream IT devices are physically connected to at least one power distribution unit (PDU) and configured to draw operating power therefrom;
and
wherein the at least one failure response includes directing the at least one PDU to disable the operating power.

4. The cooling system of any preceding claim, wherein the at least one failure response includes initiating a shutdown of the chiller device; and optionally.
wherein the cooling system is a first cooling system, the fluid network is a first fluid network, the fluid coolant is a first fluid coolant, and:
wherein the at least one failure response includes engaging at least one second cooling system operatively coupled to the controller, the at least one second cooling system configured for circulating a second fluid coolant through the one or more IT devices via a second fluid network.

5. The cooling system of any one of claims 1 to 3, wherein the at least one failure response includes initiating a shutdown of the one or more downstream IT devices; and optionally, wherein the one or more downstream IT devices are first IT devices wherein at least one workload is configured for execution, and initiating the shutdown includes one or more of: pausing the at least one executing workload; suspending the at least one executing workload; or transferring the at least one executing workload to one or more second IT devices operatively coupled to the controller.

6. The cooling system of any preceding claim, wherein the two-phase cooling system is a direct-to-chip (D2C) cooling system, and:
wherein a secondary fluid network is in thermal contact with at least one cold plate, the at least one cold plate in thermal communication with at least one of a chip or a processor of the one or more downstream IT devices.

7. A pumped two-phase cooling system, comprising:
a primary chiller device fluidly coupled to a primary fluid network, the primary chiller device including:
at least one primary pump configured to circulate a primary fluid through the primary fluid network,
and
at least one sensor configured to collect and transmit at least one property corresponding to the primary fluid leaving the primary chiller device;
a pumping unit fluidly coupled to the primary chiller device via the primary fluid network, the pumping unit including:
at least one secondary pump configured to circulate a secondary fluid between the pumping unit and one or more downstream information technology (IT) devices via a secondary fluid network;
a heat exchanger configured for thermally connecting the primary fluid network and the secondary fluid network;
a controller operatively coupled to the at least one secondary pump and wirelessly connected to the at least one sensor, the controller including at least one processor configured to:
receive from the at least one sensor the at least one property of the primary fluid;
based on the at least one property, detect a failure condition associated with the primary chiller device;
and
based on the detected failure condition, execute at least one failure response.

8. The pumped two-phase cooling system of claim 7, wherein the at least one property includes an outlet temperature of the primary fluid leaving the primary chiller device;
and/or wherein the at least one property includes a flow rate of the primary fluid leaving the primary chiller device.

9. The pumped two-phase cooling system of any one of claims 7 to 8, wherein:
wherein the one or more downstream IT devices are physically connected to at least one power distribution unit (PDU) and configured to draw operating power therefrom;
and
wherein the at least one failure response includes directing the at least one PDU to disable the operating power.

10. The pumped two-phase cooling system of any one of the claims 7 to 9, wherein the at least one failure response includes initiating a shutdown of the primary chiller device;
and optionally, wherein the cooling system is a first cooling system, and:
wherein the one or more downstream IT devices are operatively coupled to at least one backup cooling system configured to circulate a second fluid coolant through the one or more downstream IT devices via a backup fluid network;
and
wherein initiating the shutdown of the primary chiller device includes engaging the at least one backup cooling system.

11. The pumped two-phase cooling system of any one of claim 7 to 10, wherein the pumped two-phase cooling system is a direct-to-chip (D2C) cooling system, and:
wherein each of the one or more downstream IT devices includes at least one cold plate in thermal communication with at least one of a chip or a processor of the downstream IT device;
and
wherein the secondary fluid network is in direct thermal contact with the at least one cold plate.

12. The pumped two-phase cooling system of any one of claims 7 to 11, wherein:
the controller is operatively coupled to the one or more downstream IT devices;
wherein one or more workloads are configured for execution on the one or more downstream IT devices;
and
wherein the at least one failure response includes initiating a shutdown of the one or more downstream IT devices.

13. The pumped two-phase cooling system of claim 7, wherein:
the one or more downstream IT devices are first IT devices;
wherein at least one workload is configured for execution on the one or more first IT devices;
and
wherein initiating the shutdown includes one or more of:
pausing the at least one executing workload;
suspending the at least one executing workload;
or
transferring the at least one executing workload to one or more second IT devices operatively coupled to the controller.

14. A method for continuous chiller monitoring of a cooling system, the method comprising:
providing a pumping unit for a cooling system, the pumping unit configured for circulating a fluid coolant through one or more downstream information technology (IT) devices via a fluid network;
sensing, via at least one sensor of the pumping unit, at least one property of the fluid coolant leaving the pumping unit;
receiving, via a controller of the cooling system, the at least one sensed property;
detecting, via the controller and based on the at least one property of the fluid coolant, a failure condition associated with the primary chiller device;
and
executing, via the controller and based on the detected failure condition, at least one failure response, the failure response including at least one of:
initiating a shutdown of the pumping unit;
or
directing at least one power distribution unit (PDU) providing operating power to the one or more downstream IT devices to disable the operating power.

15. The method of claim 14, wherein sensing the at least one property of the fluid coolant leaving the pumping unit includes at least one of:
sensing an outlet temperature of the fluid coolant;
or
sensing a flow rate of the fluid coolant.
